(19) Europäisches Patentamt
European Patent Office
Office européen des brevets

(11) **EP 4 718 092 A1**

(12) **EUROPEAN PATENT APPLICATION**

(43) Date of publication:
**01.04.2026 Bulletin 2026/14**

(21) Application number: **24203416.3**

(22) Date of filing: **28.09.2024**

(51) International Patent Classification (IPC):
**G01R 31/367** (2019.01)    **G01R 31/392** (2019.01)
**B60L 58/16** (2019.01)

(52) Cooperative Patent Classification (CPC):
**G01R 31/392; B60L 58/16; G01R 31/367**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Hitachi Energy Ltd
8050 Zürich (CH)**

(72) Inventors:
• **Su, CuiCui
102200 Beijing (CN)**
• **Liu, Lu
100029 Beijing (CN)**
• **Meng, DeLun
100018 Beijing (CN)**
• **Jiang, Wen
102218 Beijing (CN)**
• **Yang, XiaoBo
100015 Beijing (CN)**
• **Wang, Yang
100077 Beijing (CN)**

(74) Representative: **Meier, Florian
meier ip
Buschingstraße 65 (6. OG)
81677 München (DE)**

(54) **METHOD OF PERFORMING A BATTERY DEGRADATION ASSESSMENT, DATA PROCESSING SYSTEM, AND MACHINE-READABLE INSTRUCTION CODE**

(57)    To perform a battery degradation assessment, a data processing system (20) obtains battery-related data (24) for a battery. The battery-related data (24) comprises time information for several charging and/or discharging operations. The data processing system (20) is operative to determine, based on the time information, a duration for which an operation was carried out, the operation being a charging operation (or a discharging operation. The data processing system (20) is operative to evaluate a cycling aging model (33) to determine a degradation indicator. The cycling aging model (33) comprises a power function of the duration.

FIG. 1

EP 4 718 092 A1

**Description**

TECHNICAL FIELD

Embodiments relate to methods and data processing systems useful in association with a battery, such as a battery energy storage system. Embodiments relate in particular to methods and data processing systems operative to perform a degradation assessment for a battery.

BACKGROUND

The transition from conventional energy sources to non-conventional energy sources, such as renewable energy-based sources, is an important trend in many regions of the world. The transition is desired to reduce greenhouse gas transmissions and slow or, preferably, halt climate change. A consideration that comes with the transition renewable energy-based sources relates to energy storage. Energy storage is of particular importance for power grids, such as microgrids, other distributed energy resources (DERs), regional or national grids, and the importance of energy storage increases with ever increasing renewables penetration.

Performance of batteries deteriorates gradually with time and usage, resulting in capacity and power fade,. Such battery aging behavior is influenced by various factors like battery chemistry and operation condition and/or profile. To ensure battery system safety and reliability despite aging, lifetime prediction techniques are required for determining a battery energy storage system (BESS) layout, for predictive maintenance, and/or for the operational phase.

Empirical or semi-empirical battery degradation assessment techniques provide the benefit of having a computational complexity that is low compared to other techniques, while also providing a good accuracy. Such empirical or semi-empirical techniques can be based on laboratory battery aging tests in which cell aging is evaluated when they are exposed to various stress factors. Common stress factors for cycling aging are temperature, DOD (depth of discharge), SOC (state of charge) and current.

A state of health (SOH) can be quantified, e.g., as ratio of the actual capacity at a point in time during the battery lifetime and the capacity upon installation of the battery (i.e., when the battery is in a non-degraded state). Such a SOH indicator is indicative of capacity fading. Other SOH indicators are also of interest, such as increase of an internal resistance. The SOH is useful data not only for determining when maintenance or replacement is to be performed, but also for performing control operations optimization. For illustration, the SOH for a BESS can be useful for performing control operations in association with a power grid, e.g., by curtailment of generators and/or controlling controllable loads. Thus, techniques of determining the SOH of a battery are important for various techniques, including predictive maintenance, control operations, etc., without being limited thereto.

WO 2021/044134 A1 disclose techniques useful in association with a battery degradation assessment. However, there is still a need in the art for improved techniques of assessing the degradation of a battery, such as a BESS. For illustration, conventional approaches can result in a relatively low prediction accuracy. Many conventional techniques determine an indicator for a degradation that is caused by charging and/or discharging based on a number of cycles or energy, e.g., by a number of full equivalent cycles (FECs), for assessing cycling aging. This makes the degradation assessment complex, e.g., when cycling aging and calendar aging effects are combined. This applies in particular for online techniques in which battery data is in time serials manner. Besides, aging trend in terms of a cycle number is not regular in some cases, making an accurate aging prediction model challenging.

Thus, there is an ongoing need for enhanced techniques of assessing the SOH of a battery, which may be used in association with a BESS.

SUMMARY

It is an objective of the invention to provide a method and a data processing system that provide enhanced techniques of assessing a degradation of a battery. It is an objective of the invention to provide a method and a data processing system that allow the assessment of the degradation caused by charging and/or discharging to be performed in a manner that facilitates a combination with calendar based aging techniques. It is an optional objective of the invention to provide a method and a data processing system that allow stress factors to be taken into account in a more comprehensive manner.

According to embodiments, a method, a data processing system, and a machine-readable instruction code as recited in the independent claims are provided. The dependent claims define preferred or advantageous embodiments.

According to an aspect of the invention, a method of performing a battery degradation assessment is provided. The method comprises obtaining, by a data processing system, battery-related data for a battery, the battery-related data comprising time information for several charging and/or discharging operations. The method comprises determining, by the data processing system, a degradation indicator for the battery based on the battery-related data, comprising:

determining, based on the time information, a duration for which an operation was carried out, the operation being a charging operation or a discharging operation; evaluating a cycling aging model, wherein the cycling aging model comprises a power function of the duration, wherein the degradation indicator is determined based at least on the cycling aging model.

Various effects and advantages are attained by the method. The method is operative to perform the degradation assessment in a time-based manner (at least) for periods in which charging and/or discharging is performed. The power function is a power function of the duration, not of a number of cycles or full equivalent cycles. This provides better results as compared to techniques in which a cycling aging model is evaluated as a function of a number of full equivalent cycles, e.g., by better capturing variations of the degradation behavior as a function of a stress factor such as current during the operation. The method also facilitates a combination of the results of the cycling aging model (for periods in which charging or discharging is performed) with a calendar based aging model for periods in which no charging and no discharging is performed. The calendar based aging model is different from the cycling aging model and has a different functional dependence on time (e.g., by applying a second power function to a rest duration for which no charging and no discharging is performed, with the second power function having a different exponent than the power function used in the cycling aging model). When both the cycling aging model and the calendar aging model employ duration-based functions for quantifying degradation effects, the combination of the two is facilitates. The method also facilitates the degradation assessment to be performed as an online degradation assessment, with the battery-related data comprising one or several time series (specifying, e.g., one or several stress factors as a function of time) that can be processed as the data becomes available.

As compared to conventional semi-empirical based cycling aging models which employ a cycle number (e.g., the FEC) for assessing the degradation, the method assesses the degradation during the charging and/or discharging operations based on a time-based cycling aging technique. The method facilitates the combination of cycling aging and calendar based aging techniques, to thereby capture both the effects of aging during charging and/or discharging and during periods in which no charging and no discharging is performed. Real-time battery management system (BMS) data, which may include voltage, current and temperature, is generally available as time series data and, thus, is available for processing by the method. A time-based aging model makes it easier to be implemented in an online assessment of the degradation, which uses field BMS data for assessing the degradation. A time-based cycling aging model also allows aging speed and current rate to be correlated (e.g., by accommodating variations in current), which can further improve model accuracy.

The time information may comprise a start time and an end time of the operation. Determining the duration may comprise determining the duration based on the start time and the end time.

Thereby, the data processing system is operative to assess degradation as charging and/or discharging operations are completed during field operation of the battery.

The battery-related data may comprise time-series data.

Thereby, the data processing system is operative to assess degradation based on time-series data as made available by, e.g., a BMS of a BESS.

The battery-related data may comprise at least one time-series of a current (e.g., a charging and/or discharging current of the battery).

Thereby, the data processing system is operative to process the time-series data to ascertain the duration during which the charging or discharging operation is performed. The data processing system is operative to provide the assessment of the battery degradation based on time-series data generated by the BMS, thereby facilitating the assessment to be performed as the time-series data becomes available, e.g., in (close to) real time.

The battery-related data may comprise at least one time-series of one or several stress factors other than current. The one or several stress factors may comprise one, several, or all of: temperature; state of charge (SOC); depth of discharge (DOD).

Thereby, the data processing system is operative to take into consideration the effect on the degradation that changes in the one or several stress factors have.

Determining the degradation indicator may comprise taking into account changes in the one or several stress factors that occur during the operation.

Thereby, the data processing system is operative to take into consideration the effect on the degradation caused by changes in the one or several stress factors during the charging or discharging operation (i.e., within the operation).

Determining the degradation indicator may comprise taking into account changes in the one or several stress factors that occur during the operation and one or several other charging or discharging operations.

Thereby, the data processing system is operative to take into consideration the effect on the degradation caused by changes in the one or several stress factors in different charging and/or discharging operations.

Determining the degradation indicator may comprise evaluating the cycling aging model to quantify the degradation using the time series of at least one of the stress factors and the duration determined based on the time series.

Thereby, the data processing system is operative to take into consideration the effect on the degradation caused by changes in the one or several stress factors have in different charging and/or discharging operations.

Determining the degradation indicator may comprise determining several durations, each quantifying a duration of one of the several charging and/or discharging operations. Determining the degradation indicator may further comprise evaluating the cycling aging model comprising the power function of the respective duration for each of the several charging and/or discharging operations.

Thereby, the data processing system is operative to determine the degradation indicator for each of the several charging and/or discharging operations.

Determining the degradation indicator may comprise determining an accumulated cycling aging over the several charging and/or discharging operations.

Thereby, the accumulated effect of battery degradation during several charging and/or discharging cycles may be determined.

Determining the degradation indicator may further comprise determining several rest times, each quantifying a duration of a rest period in which no charging and no discharging is performed, and wherein determining the degradation indicator further may comprise evaluating a calendar aging model comprising another power function of the respective rest time for each of the several rest periods.

Thereby, the degradation that occurs during rest times in which no charging and no discharging of the battery takes place can be quantified.

Determining the degradation indicator may comprise determining an accumulated degradation that is caused by both cycling aging over the several charging and/or discharging operations, based on the cycling aging model for the periods in which charging and/or discharging operations are performed, and by calendar aging over the several rest periods, based on the calendar aging model.

The cycling aging model may further be dependent on at least one parameter different from the duration.

Thereby, one or several additional parameters can be taken into account. This allows the correlation of stress factors other than current and/or the interdependence of current and other stress factors to be captured more accurately when determining the degradation indicator.

The at least one parameter may comprise one or several of: a temperature; a state of charge; a depth of discharge; a current rate.

Thereby, one or several stress factors are taken into account. This allows the correlation of stress factors other than current and/or the interdependence of current and other stress factors to be captured more accurately when determining the degradation indicator.

The at least one parameter may comprise a rest time.

Thereby, the effect of a preceding rest time on the degradation that occurs during charging or discharging is taken into account in the degradation assessment.

The cycling aging model may further be dependent on several parameters different from the duration, the several parameters comprising: a temperature; a state of charge; a depth of discharge; a current rate; a rest time.

Thereby, the effect of a rest time on the degradation that occurs during charging or discharging is taken into account in the degradation assessment. The rest time can precede (e.g., immediately precede) the operation which is a charging or discharging operation.

The cycling aging model may comprise a product of the power of the duration and at least one function, the at least one function being a function of the at least one parameter and being independent of the duration.

Thereby, the cycling aging model has a structure that facilitates the identification of the functional dependencies using, e.g., regression techniques and/or curve fitting. This in turn improves the accuracy of the predictions provided by the cycling aging model. In particular, a reliable determination of the cycling aging model (e.g., of the power to which the duration is raised in the cycling aging model) using regression techniques is facilitated. This configuration of the cycling aging model also facilitates a systematic determination of the cycling aging model, by using curve fitting for several stress factor values to determine the power to which the duration is raised in the cycling aging model (i.e., to determine the exponent of the duration in the cycling aging model), and to then determine the at least one function that is independent of the duration. In other words, the effects of duration of charging or discharging and of other stress factors can be considered in a systematic manner to assess the degradation with higher accuracy as compared to conventional approaches.

The at least one function may be a function of temperature, current rate, state of charge, and depth of discharge.

Thereby, the effect of the stress factors including temperature, current rate, state of charge, and depth of discharge on battery degradation are taken into account.

The at least one function may be a product of a first function that is a function of temperature, a second function that is a function of a current rate, a third function that is a function of the state of charge, and a fourth function that is a function of a depth of discharge.

Thereby, the effect of the stress factors temperature, current rate, state of charge, and depth of discharge on battery degradation are taken into account.

The first function, the second function, the third function, and the fourth function may be independent of the duration.

Thereby, the cycling aging model has a structure that facilitates the identification of the functional dependencies using, e.g., regression techniques and/or curve fitting. This in turn improves the accuracy of the predictions provided by the cycling aging model.

The first function may be independent of the current rate, the state of charge, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The first function may be an Arrhenius function.

Thereby, thermal effects on battery degradation during charging or discharging are taken into account with good accuracy.

The second function may be independent of the temperature, the state of charge, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The third function may be independent of the temperature, the current rate, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The fourth function may be independent of the temperature, the current rate, and the state of charge.

Thereby, the cycling aging model has a structure that facilitates the identification of the functional dependencies using, e.g., regression techniques and/or curve fitting. This in turn improves the accuracy of the predictions provided by the cycling aging model.

The at least one function may be a product of a first function that is a function of temperature, a second function that is a function of a current rate, a third function that is a function of the state of charge, a fourth function that is a function of a depth of discharge, and a fifth function that is a function of a rest time preceding the operation.

Thereby, the cycling aging model has a structure that facilitates the identification of the functional dependencies using, e.g., regression techniques and/or curve fitting, while taking into account the effect of rest time on the degradation. This in turn improves the accuracy of the predictions provided by the cycling aging model.

The fifth function may be independent of the temperature, the current rate, the state of charge, and the depth of discharge.

Thereby, the cycling aging model has a structure that facilitates the identification of the functional dependencies using, e.g., regression techniques and/or curve fitting, while taking into account the effect of rest time on the degradation. This in turn improves the accuracy of the predictions provided by the cycling aging model.

Determining the degradation indicator may comprise obtaining values of the at least one parameter for each of the several charging and/or discharging operations from the battery-related data.

Thereby, the effect of the stress factors on battery degradation during the operation that is a charging or discharging operation are taken into account.

Obtaining the values of the at least one parameter may comprise obtaining the values from time-series data provided by the BMS or other data resources (such as sensors and/or a data storage system).

Thereby, the effect of the stress factors on battery degradation during the operation that is a charging or discharging operation are taken into account.

Determining the degradation indicator further may comprise: identifying, based on the battery-related data, at least one time interval in which the battery is neither charged nor discharged; and evaluating a calendar aging model for the at least one time interval, the calendar aging model being different from the cycling aging model.

Thereby, the degradation assessment may be performed both for time periods in which charging and/or discharging is performed, and for time periods in which neither charging nor discharging is performed. The results of the calendar aging model and of the cycling aging model can be readily combined using a more homogeneous framework as compared to previous approaches in which cycling aging is a function of a number of cycles.

The battery-related data may originate from a BMS of the battery or an energy management system (EMS).

Thereby, the battery-related data may be processed as it becomes available from the BMS or the EMS.

Alternatively or additionally, the battery-related data may originate from another data logging system for the battery.

Thereby, the data processing system can use various data resources, such as the BMS, the EMS, and/or the data logging system, to obtain the battery-related data for performing the degradation assessment.

The battery-related data may comprise time series data captured using at least one sensor.

Thereby, the data processing system can use measurements to perform the degradation assessment, e.g., as these measurements are obtained during field operation. This facilitates performing the degradation assessment in (close to) real time.

Obtaining the battery-related data may comprise communicatively interfacing, by the data processing system, with the BMS or with the other data logging system.

Thereby, the data processing system can be provided separately from but operative to communicatively interface with the BMS or the other data logging system. This facilitates performing the degradation assessment while providing versatility as to the location of the data processing system.

Communicatively interfacing with the BMS, the EMS, or with the other data logging system may comprise establishing a data connection over a wide area network.

Thereby, the data processing system can be provided separately from but operative to communicatively interface with the BMS, EMS, or the other data logging system. This facilitates performing the degradation assessment while providing versatility as to the location of the data processing system and allowing the data processing system to perform the degradation assessment for any one of a plurality of batteries (e.g., for a plurality of BESS).

The cycling aging model may quantify a capacity reduction caused by the operation or a resistance increase caused by the operation.

Thereby, the degradation assessment can quantitatively determine important quantities that reflect aging of the battery, namely capacity fading or resistance increase.

The cycling aging model may quantify both a capacity reduction caused by the operation and a resistance increase caused by the operation. Determining the degradation indicator may comprise determining both the capacity reduction and the resistance increase.

Thereby, the degradation assessment can quantitatively determine at least two important quantities that reflect aging of the battery, namely capacity fading and resistance increase.

Thereby, the degradation assessment can quantify important quantities that reflect aging of the battery, namely capacity fading or resistance increase.

The cycling aging model may quantify another health indicator or a change in another health indicator, caused by the operation.

Thereby, the degradation assessment can determine another health indicator that quantifies the degradation of the battery.

The method may further comprise causing, by the data processing system, a control operation based on the degradation indicator.

Thereby, the degradation indicator is used to perform a control operation.

The control operation may comprise a control operation affecting equipment (e.g., primary equipment) of an electric power system that comprises a BESS comprising the battery.

Thereby, the degradation indicator is used to perform a control operation based on the degradation assessment.

The control operation may comprise any one or any combination of: controlling generator unit commitment (GUC); controlling controllable loads (e.g., by load curtailment); controlling switchgear.

Thereby, the degradation indicator is used to perform a control operation that allows power balance to be maintained, taking into account the degradation of the battery.

The method may alternatively or additionally comprise performing or initiating, by the data processing system, predictive maintenance based on the degradation indicator.

Thereby, the degradation indicator is used to perform or initiate predictive maintenance. This reduces the risk of outages. For a battery comprised by a BESS of an electric power system (e.g., a power grid), electric power system availability is enhanced.

The method may alternatively or additionally comprise performing, by the data processing system, augmentation scheduling based on the degradation indicator.

Thereby, the degradation indicator is used to perform augmentation scheduling. This reduces the lifecycle cost of the battery system. For a battery comprised by a BESS of an electric power system (e.g., a power grid), electric power system availability is enhanced.

The battery may be a battery of an electric power system (such as a power grid, microgrid, etc).

Thereby, the battery assessment is performed in association with an electric power system (such as a power grid, microgrid, distributed energy resource (DER), and/or high voltage direct current (HVDC) system) where the determination of a degradation indicator based on a cycling agent model that comprises the power of the duration (rather than a power of a cycle number or FEC number) provides enhanced accuracy as compared to legacy techniques, while mitigating the risk of an outage or other system failure for the electric power system. Thus, reliability of the electric power system is enhanced, which is of particular importance with a view to reducing the risk of infrastructure system failure.

The battery may be or may comprise a battery of a BESS of one, several, or all of: a power grid; a microgrid; a distributed energy resource (DER); a high voltage direct current (HVDC) system.

Thereby, the battery assessment is performed in association with electric power systems in which a BESS is particularly useful and where the determination of a degradation indicator based on a cycling agent model that comprises the power of the duration (rather than a power of a cycle number or FEC number) provides enhanced accuracy as compared to legacy techniques, while mitigating the risk of an outage or other system failure for the electric power system. Thus, reliability of the electric power system is enhanced, which is of particular importance with a view to reducing the risk of infrastructure system failure.

The battery may be or may comprise a traction battery of an electric vehicle.

Thereby, the battery assessment is performed in association with electric vehicles where degradation assessment is important.

The degradation assessment may be performed with the battery remaining *in situ* at an installation site of the battery and without disassembly of the battery from the BESS.

Thereby, the degradation assessment is integrated with field operation of the BESS, avoiding the downtime in BESS operation that would be associated with a disassembly of the BESS for performing the degradation assessment.

The cycling aging model may be or may comprise an empirical and/or semi-empirical cycling aging model.

Thereby, the degradation assessment can be implemented using a cycling aging model that can be established based on measurements to thereby improve the accuracy of the degradation assessment.

The method may further comprise determining the cycling aging model by the data processing system or by a computing system distinct from the data processing system. The determination of the cycling aging model may be performed as described below.

According to a further aspect of the invention, there is provided a method of determining a cycling aging model for use in battery degradation assessment (e.g., for use in the method of any aspect or embodiment disclosed herein), wherein determining the cycling aging model comprises: obtaining, by the processing system or by a computing system different from the processing system, aging test data comprising battery operating conditions and degradation indicators for at least one battery, and processing, by the processing system or by the computing system, the aging test data to determine a power function, comprising determining a power to which a duration of a charging or discharging operation is raised in the cycling aging model to model the effect of the duration on battery degradation.

Thereby, the cycling aging model for use in the method of performing a battery degradation assessment is obtainable in a data-based manner. This provides enhanced accuracy as compared to conventional techniques. The risk of human-induced error in determining parameters of the cycling aging model is reduced.

The method may further comprise providing the cycling aging model to perform the battery degradation assessment, using, e.g., the method of any aspect or embodiment disclosed herein.

Thereby, the cycling aging model determined based on the aging test data is made available to perform an empirical or semi-empirical degradation assessment.

The method may further performing, using the cycling aging model to perform, the method of performing a degradation assessment according to any aspect or embodiment disclosed herein.

Thereby, the cycling aging model determined based on the aging test data is used to perform an empirical or semi-empirical degradation assessment.

The method of determining the cycling aging model may comprise determining at least one function by which the power function of the duration is multiplied in the cycling aging model, the at least one function being a function of the at least one parameter and being independent of the duration, wherein determining the cycling aging model comprises .

Thereby, the cycling aging model is determined to have a structure that facilitates the identification of the functional dependencies using, e.g., regression techniques and/or curve fitting. This in turn improves the accuracy of the predictions provided by the cycling aging model. In particular, a reliable determination of the cycling aging model (e.g., of the power to which the duration is raised in the cycling aging model) using regression techniques is facilitated. This configuration of the cycling aging model also facilitates a systematic determination of the cycling aging model, by using curve fitting for several stress factor values to determine the power to which the duration is raised in the cycling aging model (i.e., to determine the exponent of the duration in the cycling aging model), and to then determine the at least one function that is independent of the duration. In other words, the effects of duration of charging or discharging and of other stress factors can be considered in a systematic manner to assess the degradation with higher accuracy as compared to conventional approaches.

The method of determining the cycling aging model may comprise determining the power to which the duration is raised, comprising: determining, for each of several curves that respectively define a change in a degradation indicator (such as capacity or internal resistance) as a function of duration of charging or discharging, a stress-factor dependent power to which the duration is to be raised to minimize a metric that quantifies a difference of the degradation indicator as function of duration and the duration raised to the stress-factor dependent power, the several curves comprising curves obtained for different sets of stress factors other than the duration; and processing the stress-factor dependent powers determined for the different sets of stress factors to determine the power.

Thereby, the power function can be identified in an efficient manner, taking into account the degradation represented by the aging test data for the several sets of stress factors.

Processing the stress-factor dependent powers may comprise an averaging.

Thereby, the power function can be identified in an efficient manner, taking into account the degradation represented by the aging test data for the several sets of stress factors.

Processing the stress-factor dependent powers may comprise a weighted averaging.

Thereby, the power function can be identified in an efficient manner, taking into account the degradation represented by the aging test data for the several sets of stress factors.

The method of determining the cycling aging model may comprise determining the at least one function that is a function of temperature, current rate, state of charge, and depth of discharge.

Thereby, the method can determine a cycling aging model which takes into account effects of the stress factors temperature, current rate, state of charge, and depth of discharge on battery degradation are taken into account.

The method of determining the cycling aging model may comprise determining the at least one function as a product of a first function that is a function of temperature, a second function that is a function of a current rate, a third function that is a function of the state of charge, and a fourth function that is a function of a depth of discharge.

Thereby, the method can determine a cycling aging model which takes into account effects of the stress factors temperature, current rate, state of charge, and depth of discharge on battery degradation are taken into account.

The method of determining the cycling aging model may comprise determining the at least one function such that the first function, the second function, the third function, and the fourth function may be independent of the duration.

Thereby, the cycling aging model has a structure that facilitates the identification of the functional dependencies using, e.g., regression techniques and/or curve fitting. This in turn improves the accuracy of the predictions provided by the cycling aging model.

The first function may be independent of the current rate, the state of charge, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The first function may be an Arrhenius function.

Thereby, thermal effects on battery degradation during charging or discharging are taken into account with good accuracy.

The second function may be independent of the temperature, the state of charge, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The third function may be independent of the temperature, the current rate, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

The fourth function may be independent of the temperature, the current rate, and the state of charge.

Thereby, the cycling aging model has a structure that facilitates the identification of the functional dependencies using, e.g., regression techniques and/or curve fitting. This in turn improves the accuracy of the predictions provided by the cycling aging model.

The method of determining the cycling aging model may comprise determining the at least one function such that the at least one function is a product of a first function that is a function of temperature, a second function that is a function of a current rate, a third function that is a function of the state of charge, a fourth function that is a function of a depth of discharge, and a fifth function that is a function of a rest time.

Thereby, the cycling aging model has a structure that facilitates the identification of the functional dependencies using, e.g., regression techniques and/or curve fitting, while taking into account the effect of rest time on the degradation. This in turn improves the accuracy of the predictions provided by the cycling aging model.

The fifth function may be independent of the temperature, the current rate, the state of charge, and the depth of discharge.

Thereby, the cycling aging model has a structure that facilitates the identification of the functional dependencies using, e.g., regression techniques and/or curve fitting. This in turn improves the accuracy of the predictions provided by the cycling aging model.

Other optional features of the method of determining the cycling aging model and the effects attained thereby correspond to the optional features discussed in association with the method of performing a battery degradation assessment.

The degradation indicators processed to determine the cycling aging model may comprise degradation indicators (such as capacitance and/or resistance) of test batteries determined by performing forced aging (in which the test batteries may be deliberately exposed to various stress factors) and determining the respective degradation indicators (such as capacitance and/or resistance) based on measurements (such as by charging and/or discharging cycles that allow the capacitance and/or resistance to be determined).

Thereby, the cycling aging model has a structure that facilitates the identification of the functional dependencies using, e.g., regression techniques and/or curve fitting, while taking into account the effect of rest time on the degradation. This in turn improves the accuracy of the predictions provided by the cycling aging model.

According to another aspect of the invention, there is provided machine-readable instruction code comprising machine-readable instructions which, when executed by at least one processing circuit, cause the at least one processing circuit to perform the method according to an aspect or embodiment of the invention.

The effects attained by the machine-readable instruction code correspond to the effects disclosed in association with the methods and systems according to various embodiments.

According to another aspect of the invention, there is provided a non-transitory storage medium having stored thereon machine-readable instruction code comprising machine-readable instructions which, when executed by at least one processing circuit, cause the at least one processing circuit to perform the method according to an aspect or embodiment of the invention.

The effects attained by the non-transitory storage medium correspond to the effects disclosed in association with the methods and systems according to various embodiments.

According to another aspect of the invention, there is provided a data processing system for performing a battery degradation assessment. The data processing system comprises at least one interface operative to obtain battery-related data for a battery, the battery-related data comprising time information for several charging and/or discharging operations. The data processing system comprises at least one processing circuit operative to determine a degradation indicator for the battery based on the battery-related data, the at least one processing circuit being operative to: determine, based on the time information, a duration for which an operation was carried out, the operation being a charging operation or a discharging operation; evaluate a cycling aging model, wherein the cycling aging model comprises a power function of the duration, wherein the degradation indicator is determined based at least on the cycling aging model.

Various effects and advantages are attained by the data processing system. The data processing system is operative to perform the degradation assessment in a time-based manner (at least) for periods in which charging and/or discharging is performed. The power function is a power function of the duration, not of a number of cycles or full equivalent cycles. This provides better results as compared to techniques in which a cycling aging model is evaluated as a function of a number of full equivalent cycles, e.g., by better capturing variations of the degradation behavior as a function of a stress factor such as current during the operation. The data processing system also facilitates a combination of the results of the cycling aging model (for periods in which charging or discharging is performed) with a calendar based aging model for periods in which no charging and no discharging is performed. The calendar based aging model is different from the cycling aging model and has a different functional dependence on time (e.g., by applying a second power function to a rest duration for which no charging and no discharging is performed, with the second power function having a different exponent than the power function used in the cycling aging model). When both the cycling aging model and the calendar aging model employ duration-based functions for quantifying degradation effects, the combination of the two is facilitates. The data processing system also facilitates the degradation assessment to be performed as an online degradation assessment, with the battery-related data comprising one or several time series (specifying, e.g., one or several stress factors as a function of time) that can be processed as the data becomes available.

As compared to conventional semi-empirical based cycling aging models which employ a cycle number (e.g., the FEC) for assessing the degradation, the data processing system is operative to assess the degradation during the charging and/or discharging operations based on a time-based cycling aging technique. The data processing system facilitates the combination of cycling aging and calendar based aging techniques, to thereby capture both the effects of aging during charging and/or discharging and during periods in which no charging and no discharging is performed. Real-time battery management system (BMS) data, which may include voltage, current and temperature, is generally available as time series data and, thus, is available for processing by the data processing system. A time-based aging model makes it easier to be implemented in an online assessment of the degradation, which uses field BMS data for assessing the degradation. A time-based cycling aging model also allows aging speed and current rate to be correlated (e.g., by accommodating variations in current), which can further improve model accuracy.

The data processing system may be operative to perform the method according to any aspect or embodiment.

Optional features of the data processing system according to various embodiments and the effects attained thereby correspond to the optional features and effects discussed in association with the methods according to embodiments.

The data processing system may be comprised by or communicatively interfaced with a BMS and/or a power conversion system (PCS).

According to another aspect, there is disclosed a system, comprising a BESS comprising at least one battery and the data processing system according to an aspect or embodiment operative to perform the battery degradation assessment for the at least one battery.

Thereby, the effects discussed in association with the data processing method and data processing system are attained.

The system may be an electric power system, such as an electric power grid (e.g., a microgrid) or a sub-system thereof, such as a power system substation, without being limited thereto. The system may comprise a microgrid comprising renewable energy sources. The system may comprise or may be a DER. The system may comprise or may be a HVDC system.

Embodiments of the invention provide enhanced techniques of performing a degradation assessment for a BESS. The method and data processing system according to embodiments allows the degradation assessment in a manner that provides enhanced accuracy as compared to conventional techniques, such as conventional techniques using empirical and/or semi-empirical cycling aging models. The method and data processing system also allow the degradation assessment to be performed in a manner that is particularly suitable for combining results of a cycling aging model (applied to assess the battery degradation during one or several charging and/or discharging operations) with results of a calendar aging model (applies to assess the battery degradation during rest periods between charging and/or discharging operations).

BRIEF DESCRIPTION OF THE DRAWINGS

Embodiments of the invention will be described with reference to the drawings in which similar or identical reference signs designate elements with similar or identical configuration and/or function.

Fig. 1 is a block diagram representation of a data processing system operative to perform a degradation assessment for a battery.
Fig. 2 is a block diagram representation of a system comprising a battery and a data processing system operative to perform a degradation assessment for the battery.
Fig. 3 is a flow chart of a method of performing a degradation assessment.
Fig. 4 is a block diagram representation of at least one processing circuit of a data processing system operative to perform a degradation assessment for a battery.
Fig. 5 is a flow chart of a method of performing a degradation assessment.
Fig. 6 is a schematic representation of operations to which a battery is subjected.
Fig. 7 is a schematic representation of a cycling aging model of the data processing system and method.
Fig. 8 shows a degradation indicator as a function of a number of equivalent full cycles.
Fig. 9 shows a degradation indicator as a function of a number of equivalent full cycles.
Fig. 10 shows a degradation indicator as a function of a duration of a period throughout which a charging or discharging operation was performed.
Fig. 11 shows a first function of a cycling aging model that is dependent on a current rate.
Fig. 12 shows a measured capacity fading (closed circles) and results obtained by a cycling aging model (broken line) using the data processing system and method according to an embodiment for a set of stress factors.
Fig. 13 shows a measured capacity fading (closed circles) and results obtained by a cycling aging model (broken line) using the data processing system and method according to an embodiment for another set of stress factors.
Fig. 14 shows a measured capacity fading (closed circles) and results obtained by a cycling aging model (broken line) using the data processing system and method according to an embodiment for a set of stress factors.
Fig. 15 shows a measured capacity fading (closed circles) and results obtained by a cycling aging model (broken line) using the data processing system and method according to an embodiment for another set of stress factors.
Fig. 16 is a flow chart of a method of performing the degradation assessment.
Fig. 17 is a flow chart of a method of providing a cycling aging model.
Fig. 18 is a flow chart of a method of providing a cycling aging model.
Fig. 19 is a schematic representation of a system comprising the data processing system operative to perform a degradation assessment for a battery.
Fig. 20 is a schematic representation of a system comprising the data processing system operative to perform a degradation assessment for a battery.

DETAILED DESCRIPTION OF EMBODIMENTS

Embodiments of the invention will be described with reference to the drawings. In the drawings, similar or identical reference signs designate elements with similar or identical configuration and/or function.
Embodiments relate to methods, data processing systems, and systems useful in association with performing a degradation assessment for a battery. Battery cells of a BESS or other batteries degrade, resulting in a reduction in capacity due to the degradation of active material on cathode and/or anode. Solid Electrolyte Interphase (SEI) formation is one of the further root causes for a reduction of battery capacity over time. Degradation may also result in a resistance increase.
Battery cells are often considered as having a higher malfunction probability when the remaining capacity is below 80% of their Beginning of Life (BOL) value. Thus, it is desirable to monitor the effect of various operations (such as an operation that is a charging or discharging operation; or keeping the battery without current through a rest period) on battery degradation. The monitored battery degradation can be used for various operations, such as control operations acting on an electric power system, predictive maintenance, and/or augmentation scheduling.

During field operation, it may be challenging to find an opportunity to conduct a 0-100% Depth of Discharge (DOD) charging / discharging cycle to determine the full capacity of battery cells. Thus, it is particularly desirable to provide techniques capable of performing a degradation assessment without requiring a full 0-100% DOD charging / discharging cycle, based on data acquired during online operation of the battery.

The methods, data processing systems, and systems according to embodiments are operative to determine at least one degradation indicator for a battery, using a cycling aging model to assess battery degradation in periods in which charging and/or discharging operations are performed. A calendar aging model different from the cycling aging model may be used in addition to assess battery degradation in rest periods in which no charging and no discharging is performed.

As used herein, the term "degradation assessment" refers to a process capable of determining one or several quantities indicative of the degradation of the battery.

As used herein, the term "degradation indicator" refers to at least one quantity that is indicative of the degradation of the battery. The degradation indicator may quantify the degradation as a numerical value. The term degradation indicator, as used herein, encompasses any one, or any combination of:

- a degradation indicator indicative of (e.g., quantifying) capacity fading;
- a degradation indicator that represents (e.g., that approximates) a capacitance of the battery as compared to a BOL capacitance (e.g., as a fraction of the capacitance at a point in time during field operation, divided by the BOL capacitance);
- a degradation indicator that represents (e.g., that approximates) a change in capacitance of the battery during an operation that is a charging or discharging operation (e.g., as a fraction of a final capacitance at an end of the operation and an initial capacitance at a start of the operation);
- a degradation indicator indicative of (e.g., quantifying) an internal resistance increase;
- a degradation indicator that represents (e.g., that approximates) an internal resistance of the battery as compared to a BOL resistance (e.g., as a fraction of the resistance at a point in time during field operation, divided by the BOL resistance);
- a degradation indicator that represents (e.g., that approximates) a change in internal resistance of the battery during an operation that is a charging or discharging operation (e.g., as a fraction of a final resistance at an end of the operation and an initial final at a start of the operation);
- a degradation indicator indicative of (e.g., quantifying) another SOH quantifier or change in SOH quantifier.

These are non-limiting examples for degradation indicators.

As used herein, determination of a degradation indicator encompasses scenarios in which several degradation indicators are determined. For illustration, the data processing system may be operative such that performing the degradation assessment comprises determining both capacity fading and resistance increase that occur during a charging or discharging operation.

As used herein, the term "cycling aging model" refers to a technique that processes battery-related data or model input data generated from the battery-related data to determine the degradation indicator that specifies the effect of a charging or discharging operation on battery degradation. The cycling aging model may be represented by a function that maps a set of data elements of the battery-related data or of the model input data to the degradation indicator. In other words, the cycling aging model may comprise or may be represented by an equation that, when evaluated using the battery-related data or model input data generated from the battery-related data, provides the degradation indicator for an operation that is a charging operation or a discharging operation.

The term "cycling aging model" does not imply that a full charging cycle and/or a fully discharging cycle must be completed. The cycling aging model, as used herein, is applicable to determine the degradation indicator for an operation that is a charging or discharging operation, even when no full charging cycle and/or no full discharging cycle was completed. Thus, the cycling aging model is applicable to an operation which is a partial charging (as compared to a full charging cycle) or a partial discharging (as compared to a full discharge cycle).

The term cycling aging model is different from a calendar aging model. The former determines the degradation indicator over a rest period in which neither charging nor discharging is performed.

As used herein, the term "duration" of a period in which an operation is carried out refers to a duration as determined from a start of the operation, e.g., to an end of the duration (or an intermediate point of time at which charging or discharging is still ongoing, but for which the degradation indicator is of interest). The duration may be a dimensionless quantity, i.e., the term "duration" as used herein refers to a (rational or irrational number) that specifies the time over which the operation has been ongoing in suitable units (such as seconds or minutes).

The cycling aging model may be a function of the duration and may, in particular, include a power function of the duration. As used herein, and in accordance with conventional terminology in the art, the term power function of duration refers to a function of the form $A \times t^z$, where A is a coefficient (which may but does not need to be present), t represents duration of the operation (which may be specified as a dimensionless number that indicates the time period over which the operation is ongoing in suitable units, such as a seconds or minutes), and z is the power to which the duration is raised in the power function. The quantity "z" is also referred to as power, exponent (in the sense of exponent of the duration in the power function), or power factor. The exponent z need not be integer, but may rather be a non-integer value. The exponent z may be 0.5 or more and 1.0 or less.

As used herein, the term "time information" encompasses, but is not limited to, a data item that specifies a duration. The time information may be any data that implicitly or explicitly specifies the duration of an operation that is a charging or discharging operation. For illustration, the time information may be included in time series data that specifies the current as a function of time, allowing the duration of the operation to be determined.

As used herein, the term "charging operation" also encompasses a partial charging operation, i.e., a charging operation that does not cover the full 0-100% DOD range.

As used herein, the term "discharging operation" also encompasses a partial discharging operation, i.e., a discharging operation that does not cover the full 100-0% DOD range.

As used herein, the term "calendar aging model" refers to a technique that processes battery-related data or calendar aging model input data generated from the battery-related data to assess degradation for a period in which no charging or discharging was performed, e.g., a rest period. The calendar aging model may be represented by a function that maps a set of data elements of the battery-related data or of the calendar aging model input data to a quantity that is indicative of degradation during the rest time. In other words, the cycling aging model may comprise or may be represented by an calendar aging model equation that, when evaluated using the battery-related data or calendar aging model input data generated from the battery-related data, provides a quantity that is indicative of degradation during the rest time. The calendar aging model may include a further power function in which a rest time is raised to a further power. A further exponent that indicates the further power to which the rest time is raised in the further power function can be (and generally is) different from the exponent z that of the power function of the cycling aging model.

As used herein, "battery-related data" encompasses data that indicates time information for battery operation states. The battery-related data may comprise time-series data, e.g., of currents, that can be processed to determine the duration of an operation that is a charging or discharging operation. The battery-related data may comprise time series of additional parameter values, such as for temperature, SOC (e.g., a middle SOC), DOD, without being limited thereto.

As used herein, a battery degradation assessment may be performed as an online battery degradation assessment, i.e., as a battery degradation assessment performed during field operation of the battery without requiring disassembly of the battery and/or performance of a 0-100% DOD charging/discharging cycle.

As used herein, the "battery" may be a battery of a BESS of an electric power system (such as a power grid, a microgrid, a DER, an electric power system comprising a DER, a HVDC system). The "battery" may be a vehicle battery, e.g., a traction battery of or for a vehicle.

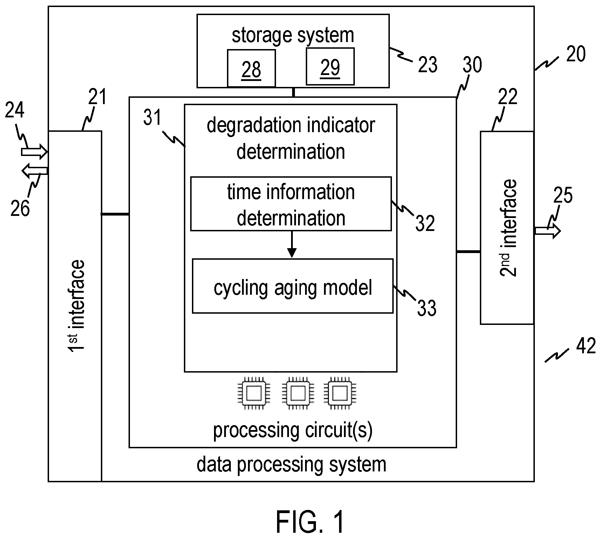

Fig. 1 shows a schematic representation of a data processing system 20 operative to perform a degradation assessment for a battery, e.g., of a BESS of an electric power system.

The data processing system 20 comprises at least one first interface 21 operative to be receive battery-related data 24. The at least one first interface may be operative for communicatively interfacing the data processing system 20 with measurement instrumentation, a BMS, a power control system (PCS), and/or other data acquisition and/or logging systems to obtain the battery-related data. The battery-related data 24 may comprise one or several time series. The battery-related data 24 may comprise at least one current time series indicating charging or discharging current as a function of time during an operation that is a charging or discharging operation. The battery-related data 24 may comprise other data that allows a duration of the operation to be determined, with the operation being a charging or discharging operation. The battery-related data 24 may comprise one or several other time series that specify or allow determination of stress factors, such as temperature, SOC (e.g., a middle SOC, which may be a mean or median SOC during the operation), DOD, etc.

The data processing system 20 is operative to process the battery-related data 24 to perform the battery degradation assessment. The data processing system 20 is operative to evaluate a cycling aging model 33 to determine the battery degradation assessment. Evaluating the cycling aging model 33 comprises determining, by at least one processing circuit 30 of the data processing system 20, a power function of a duration of an operation that is a charging or discharging operation, to determine the degradation indicator that quantifies battery degradation during the operation.

The data processing system 20 may be operative to generate output 25, 26 based on a degradation indicator that quantifies battery degradation during the operation. The data processing system 20 may be operative such that the output generated based on the degradation indicator comprises control data 26. The control data 26 may comprise control data that affects primary system equipment of an electric power system comprising the BESS. The control data 26 may comprise control data that affects generator unit commitment (GUC) of generators and/or that affects controllable loads.

The control data 26 may comprise control data that affects components of a HVDC system.

Alternatively or additionally, the data processing system 20 may comprise at least one second interface 22. The at least one second interface 22 may comprise a human machine interface (HMI) or may be operative to communicatively interface with the HMI to provide the output 25 based on the degradation indicator.

The data processing system 20 comprises a storage system 23 and the at least one processing circuit 30. The at least one processing circuit 30 is operative to be communicatively coupled with the at least one first interface 21 and, if present, with the at least one second interface 22. The at least one processing circuit 30 may be operative to access the storage system 23 of the data processing system 20 or coupled to the data processing system 20. The storage system 23 may have stored therein parameter values of several parameters 28 specifying the cycling aging model 33. The parameters 28 specifying the cycling aging model 33 comprise at least the exponent z to which the duration t of the operation is raised in the cycling aging model 33. The parameters 28 may further comprise parameters of a first function, a second function, a third function, and a fourth function, with the cycling aging model 33 determining the degradation indicator that quantifies degradation for the operation based on a product of (at least) the first, second, third, and fourth functions and the power function of the duration. The data processing system 20 may be operative such that the first function is a function of temperature, the second function is a function of a current rate, the third function is a function of the state of charge, and the fourth function is a function of a depth of discharge, thereby quantifying how these various stress factors contribute to the degradation during the operation.

The storage system 23 may have stored therein parameter values of several parameters 29 specifying a calendar aging model. The parameters 29 specifying the calendar aging model comprise at least a further exponent to which the duration of a period in which no charging and no discharging is performed is raised in the calendar aging model, with the further exponent being different from the exponent in the parameters 28 of the cycling aging model 33.

The parameter values of the parameters 28 and, if present, the parameter values of the parameters 29 may comprise several distinct sets of predefined different parameter values, each associated with a different battery cell type (such as lithium iron phosphate battery (LFP), nickel-manganese-cobalt (NMC), lithium-titanate-oxide (LTO), etc.). The values of the parameters 28 and, if present, the parameter values of the parameters 29 may comprise may comprise parameter values set based on offline battery aging tests.

The at least one processing circuit 30 is operative to process the battery-related data 24 to implement a degradation indicator determination 31. The at least one processing circuit 30 is operative to perform a time information determination 32 to determine, e.g., based on time series data, a duration of the operation that is the charging or discharging operation for which the degradation indicator is to be determined. The at least one processing circuit 30 is operative to process the duration using the cycling aging model 33. Processing the duration using the cycling aging model 33 may comprise determining the power function of the duration, with the duration being raised to the power z in the power function of the cycling aging model 33. Processing the battery-related data to perform the degradation indicator determination 31 may comprise establishing, based on the battery-related data, temperature, current rate, DOD, and SOC and evaluating a product of (at least) the first, second, third, and fourth functions and the power function of the duration, wherein the first function is a function of temperature, the second function is a function of a current rate, the third function is a function of the state of charge, and the fourth function is a function of a depth of discharge.

The at least one processing circuit 30 may be operative to generate output 25, 26 for outputting via the at least one first interface 21 and/or the at least one second interface 22, based on a result of the cycling aging model.

To perform the mentioned operations, the at least one processing circuit 30 may comprise any one or any combination of integrated circuits, integrated semiconductor circuits, processors, controllers, graphics processing units (GPUs), tensor processing units (TPUs), central processing units (CPUs), application specific integrated circuits (ASICs), field programmable gate arrays (FPGAs), circuit(s) including quantum bits (qubits) and/or quantum gates, without being limited thereto.

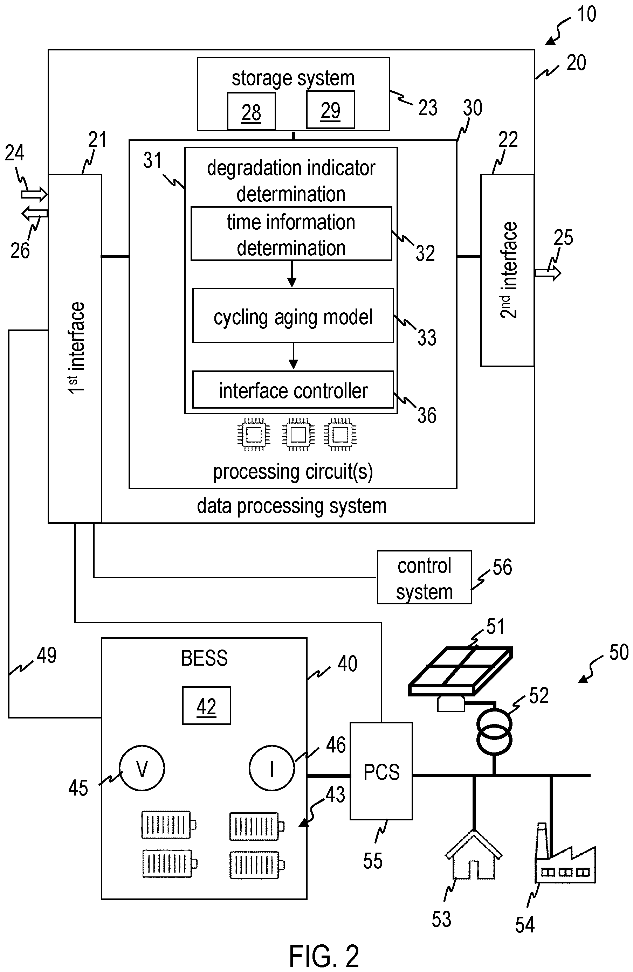

Fig. 2 shows a schematic representation of a system 10. The system 10 may be an electric power system that comprises electric power system equipment 50 and the data processing system 20 operative to perform a degradation assessment for a battery of a BESS 40. The electric power system comprises the BESS 40. The electric power system may comprise a power grid, such as a microgrid and/or a distributed energy resource (DER), comprising one or several renewable power sources 51 coupled to a bus via a transformer, converter, or a converter/inverter 52. The electric power grid may comprise one or several loads 53, 54. The one or several loads 53, 54 may comprise at least one load that can be curtailed or otherwise controlled, depending on the energy available from the energy source(s) and the BESS 40. The electric power system 50 may comprise a control system 56 operative to control one or several renewable energy sources, such as by controlling generator unit commitment (GUC) (e.g., by controlling setpoints for photovoltaic or wind energy sources). The control system 56 may be operative to control one or several controllable loads, e.g., by causing load curtailment to be performed. The data processing system 20 may be operative to provide the output 25 to allow the control system 56 to perform an action based on the degradation indicator. The data processing system 20 may be operative to provide the output 25, 26 for performance of preventive maintenance and/or augmentation scheduling.

The BESS 40 may be coupled to a bus or line of the electric power system 50 via the PCS 55. The BESS 40 is operative to receive electric power via the PCS 55, store the electric power in plurality of batteries 43 of the BESS 40, and to provide the stored electric power via the PCS 55. The BESS 40 may comprise or may be coupled to a BMS 42. The BMS 42 need not be integrated into the BESS 40, but may also be provided separately therefrom, e.g., as a separate component or integrated with the PCS 55.

The system 10 may comprise measurement instrumentation operative to obtain current measurements. The measurement instrumentation may comprise current measurement instrumentation 46, optionally also voltage measurement instrumentation 45. The current measurement instrumentation 46 may be operative to measure the charging current during BESS charging and the discharging current during BESS discharging. The current measurements may be obtained continually, i.e., on an ongoing basis. The current measurements may be captured at least while the BESS 40 is charged or is discharged. The data processing system 20 may be operative to process the current measurements captured charging or discharging of the BESS 40. The data processing system 20 is operative to process battery-related data 24 that comprise current measurements to perform the battery degradation assessment.

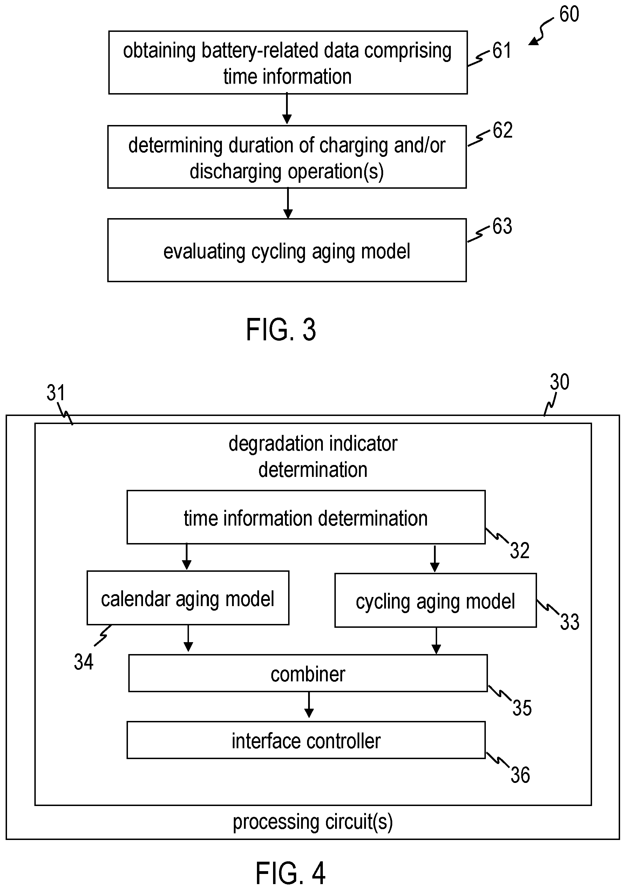

Fig. 3 is a flow chart of a method 60 of performing a battery degradation assessment, e.g., for a BESS. The method 60 may be performed automatically by the data processing system 20 and/or by the system 10.

At process block 61, battery-related data is obtained. Obtaining the battery-related data may comprise communicatively interfacing, by the data processing system 20, with the BMS 42 or with another data logging and/or acquisition system for the battery-related data. The battery-related data comprises time information that allows a duration of a charging or discharging operation to be determined.

At process block 62, the duration of an operation that is a charging or discharging operation is determined based on the battery-related data. Determining the duration may comprise evaluating a time series of, e.g., current measurements to determine the duration of the operation. The duration may be the duration from the start to the end of the charging or discharging operation.

At process block 63, a cycling aging model is evaluated to determine a battery degradation indicator that quantifies degradation during the operation. Evaluating the cycling aging model comprises evaluating a power function of the duration. Evaluating the cycling aging model may comprise evaluating first, second, third, and fourth functions and the power function of the duration, wherein the first function is a function of temperature, the second function is a function of a current rate, the third function is a function of the state of charge, and the fourth function is a function of a depth of discharge, and determining a product of (at least) the first, second, third, and fourth functions and the power function of the duration.

The method 60 may further comprise controlling at least one interface 21, 22 to provide output 25, 26 based on the determined battery degradation indicator.

Fig. 4 is a schematic block diagram representation of the at least one processing circuit 30. The at least one processing circuit 30 operative as disclosed in association with Fig. 4 may be implemented in the data processing system 20 of Fig. 1 and/or the system 10 of Fig. 2.

The at least one processing circuit 30 implements a time information determination 32. For an operation that is a charging or discharging operation, the time information determination 32 provides a duration of the operation. The cycling aging model evaluation 33 is operative to process the duration of the operation, including the evaluation of a power function of the duration of the operation.

For a rest period in which no charging and no discharging is performed, the time information determination 32 provides a duration of the rest period (also referred to as rest time). The at least one processing circuit 30 implements a calendar aging model evaluation 34 to process the duration of the rest period, including the evaluation of a further power function of the duration of the rest period

The at least one processing circuit 30 is operative to implement a combiner 34 operative to combine results obtained by the cycling aging model evaluation 33 for one or several charging and/or discharging operations, and the results obtained by the calendar aging model evaluation 34 for one or several rest periods. The combiner 34 may be operative to determine an accumulated degradation from the degradation indicators for several charging and/or discharging operations, optionally also based on the degradation indicators for one or several rest periods. The implementation of the combiner 34 may vary depending on the implementation of the degradation indicator(s). For illustration, for degradation indicator(s) that specify capacity fading and/or resistance increase respectively in relation to a base value (such as the capacitance and/or resistance at BOL of the battery), the combiner 34 may be operative to sum up the changes in capacitance and/or resistance to determine an overall degradation over the several charging and/or discharging operations, optionally also for one or several rest periods.

The at least one processing circuit 30 is operative to implement an interface control to control the provision of output 25, 26 via at least one interface 21, 22, based on the determined degradation indicator.

To perform the mentioned operations, the at least one processing circuit 30 may comprise any one or any combination of integrated circuits, integrated semiconductor circuits, processors, controllers, graphics processing units (GPUs), tensor processing units (TPUs), central processing units (CPUs), application specific integrated circuits (ASICs), field programmable gate arrays (FPGAs), circuit(s) including quantum bits (qubits) and/or quantum gates, without being limited thereto.

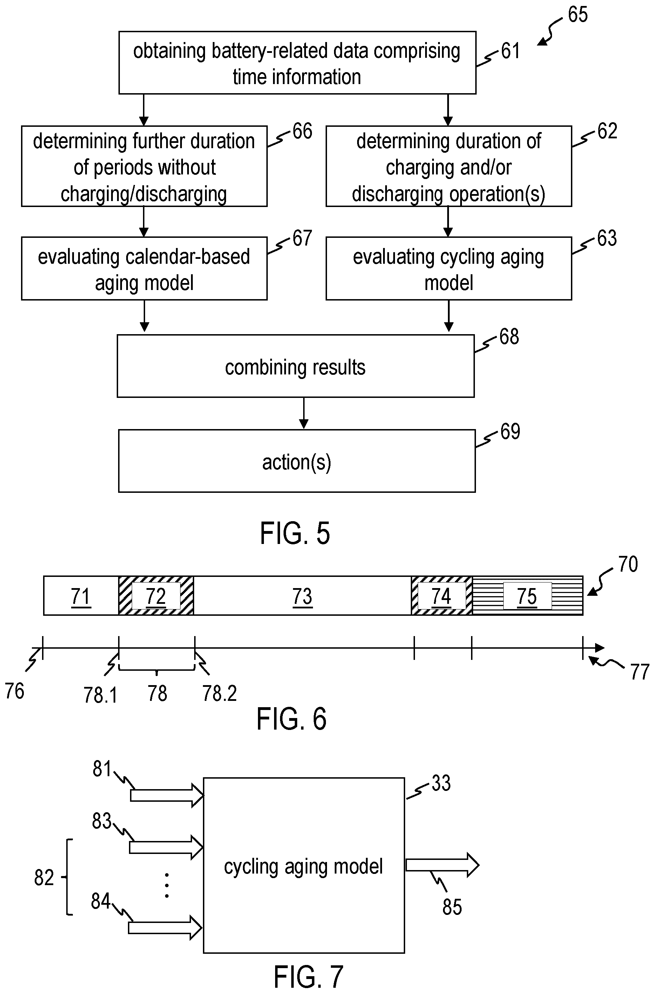

Fig. 5 is a flow chart of a method 65 of performing a battery degradation assessment, e.g., for a BESS. The method 65 may be performed automatically by the data processing system 20 and/or by the system 10.

Process blocks 61, 62, and 63 may be performed as explained with reference to Fig. 3.

At process block 66, a further duration of a rest period is determined in which no charging and no discharging operation is performed, based on the battery-related data. Determining the further duration may comprise evaluating a time series of, e.g., current measurements to determine the further duration of the rest period. The further duration may be determined from a start to an end of the rest period.

At process block 67, a calendar aging model is evaluated to determine a battery degradation indicator that quantifies degradation during the rest period. Evaluating the calendar aging model comprises evaluating a further power function of the duration. Evaluating the calendar aging model may comprise evaluating the calendar aging model further based on one or several stress factors such as SOC and/or DOD.

At process block 68, the results of the cycling aging model and of the calendar aging model are combined. Thereby, an accumulated degradation can be determined.

At process block 69, an action is initiated based on the combination of the results of the cycling aging model and of the calendar aging model. The action may comprise a control action that affects electric power system equipment (e.g., by modifying GUC and/or by performing load curtailment). The action may comprise an initiation of a predictive maintenance and/or augmentation scheduling. The action may comprise automatically initiating a communication link to initiate the predictive maintenance and/or augmentation scheduling.

Fig. 6 is a schematic representation illustrating a sequence 70 of operational states of a battery (e.g., of a BESS). The sequence 70 comprises one or several charging operations 72, 74 and one or several discharging operations 75. The sequence 70 may also comprise rest periods 71, 73 in which no charging and no discharging is performed.

Fig. 6 also illustrates start and end times (collectively designated by reference number 77) of the various operational states shown along a time axis 76. The data processing system 20 and/or the method are operative to determine a duration 78 of an operation that is a charging or discharging operation. The duration 78 may be determined as full duration from a start time 78.1 to an end time 78.2. Evaluating the cycling aging model may comprise evaluating the power function of the duration 78.

Fig. 7 shows a schematic representation of the cycling aging model 80. The cycling aging model 80 may be comprised by the data processing system 20 and/or the system 10. The cycling aging model 33 may map input that comprises a duration 81 of an operation that is a charging or discharging operation, optionally in association with other stress factors 82 (such as temperature 83, SOC 84, DOD) to an output 85 that is a degradation indicator. Thus, the cycling aging model 33 is a model that is operative to process input comprising the duration of the operation to generate, as output, the degradation indicator that is indicative of the degradation during the operation.

The techniques disclosed herein provide various effects, including ease of combinability of cycling aging model and calendar aging model results, and enhanced accuracy as compared to legacy techniques. For illustration, the techniques disclosed herein, in which the cycling aging model includes a power function of the duration, provide a more systematic and more accurate approach to capture the interdependence of duration and current rate during a charging or discharging operation as compared to conventional techniques.

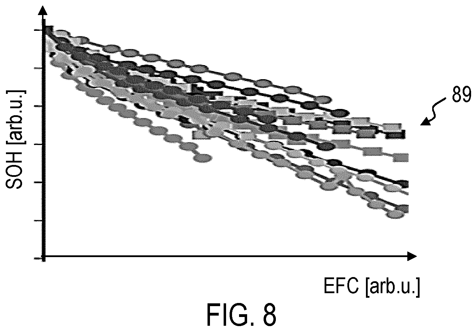

Fig. 8 shows various curves 89 representing a degradation indicator (more specifically, for Fig. 8, the capacity divided by the BOL capacity) as a function of an equivalent full cycle (EFC) number. The data were obtained by a 50-80% DOD charging/discharging cycle for the specific purpose of quantifying the capacity fading, respectively for different numbers of EFCs. The various curves 89 have a dependence on stress factors such as current rate that can exhibit a non-monotonous behavior, which makes it challenging to capture the dependence of the battery degradation on such stress factors when using EFC-based approaches for cycling aging. Different curves are distinguished by stress factors such as current rate.

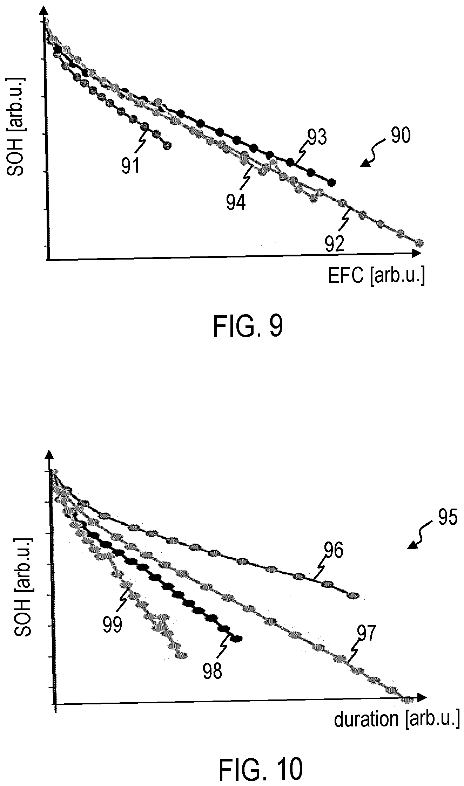

Fig. 9 shows various curves 90 representing a degradation indicator (more specifically, for Fig. 9, the capacity divided by the BOL capacity) as a function of an equivalent full cycle (EFC) number. The different curves are distinguished by the current rate for which they were obtained. The data were obtained by a 50-80% DOD charging/discharging cycle for the specific purpose of quantifying the capacity fading, respectively for different numbers of EFCs. A first curve 91 was obtained for a first current rate. A second curve 92 was obtained for a second current rate that is greater than the first current rate. A third curve 93 was obtained for a third current rate that is greater than both the first current rate and the second current rate. A fourth curve 94 was obtained for a fourth current rate that is greater than the first, second, and third current rates. The data of the first, second, third, and fourth curves 91-94 were obtained for a same DOD (in the present case, 50-80% DOD). Thus, as evidenced by Fig. 9, a cycling aging model that is based on the EFCs (i.e., that quantifies capacity fading and/or resistance increase as a function of EFC) exhibits a complex behavior on at least one other stress factor, notably current rate.

Fig. 10 shows various curves 95 representing a degradation indicator (more specifically, for Fig. 10, the capacity divided by the BOL capacity) as a function of duration of charging and/or discharging operations. The different curves are distinguished by the current rate for which they were obtained. The data of the various curves 95 were obtained for a same DOD (in the present case, 50-80% DOD). The data were obtained by a 50-80% DOD charging/discharging cycle for the specific purpose of quantifying the capacity fading, respectively as a function of duration. A first curve 96 was obtained for the first current rate. A second curve 97 was obtained for a second current rate that is greater than the first current rate. A third curve 98 was obtained for a third current rate that is greater than both the first current rate and the second current rate. A fourth curve 99 was obtained for a fourth current rate that is greater than the first, second, and third current rates. Thus, as evidenced by Fig. 10, a cycling aging model that is based on duration of charging and/or discharging operations (i.e., that quantifies capacity fading and/or resistance increase as a function of the duration) exhibits a simpler dependency on current rate than a cycling aging model that is based on EFC (as shown in Fig. 8 and Fig. 9).

The more systematic dependency is exploited by the method and data processing system disclosed herein, with the cycling aging model being a power function of duration (and not of a EFC), thereby allowing the dependency on other stress factors to be captured in a manner that provides enhanced accuracy of the degradation assessment.

Thus, referring again to Fig. 1 to Fig. 10, the method and data processing system according to embodiments are operative to determine the degradation using a cycling aging model that comprises a power function of a duration of an operation that is a charging or discharging operation.

The cycling aging model may comprise an equation having the following form:

$$C_{loss,cyc} = \beta_T(T) \times \beta_{C-rate}(C-rate) \times \beta_{SOC}(SOC) \times \beta_{DOD}(DOD) \times t^z \qquad (1)$$

In Equation (1), the various quantities are as follows: $C_{loss,cyc}$ denotes a capacity fading caused by cycling aging; t denotes the duration of the operation; z denotes the power to which the duration is raised, with z being generally 0.5 or more and 1.0 or less; $T$ denotes temperature; $C$-rate denotes a current rate; SOC denotes a middle state of charge (such as a mean or median SOC during the operation); DOD denotes a depth of discharge; $\beta_T(\cdot)$ denotes a first function that is a function of temperature and that is independent of the duration, the current rate, the SOC, and the DOD; $\beta_{C-rate}(\cdot)$ denotes a second function that is a function of current rate and that is independent of the duration, the temperature, the SOC, and the DOD; $\beta_{SOC}(\cdot)$ denotes a third function that is a function of SOC and that is independent of the duration, the temperature; the current rate, and the DOD; and $\beta_{DOD}(\cdot)$ denotes a fourth function that is a function of DOD and that is independent of the duration, the temperature; the current rate, and the SOC.

The first function $\beta_T(\cdot)$ may be an Arrhenius function. For illustration, the first function $\beta_T(\cdot)$ may be of the form:

$$\beta_T(T) = D_1 \times e^{-D_2/(T[K])} \qquad (2)$$

or

$$\beta_T(T) = D_1 \times e^{-D_2/(T[°C]+273.15)} \qquad (3),$$

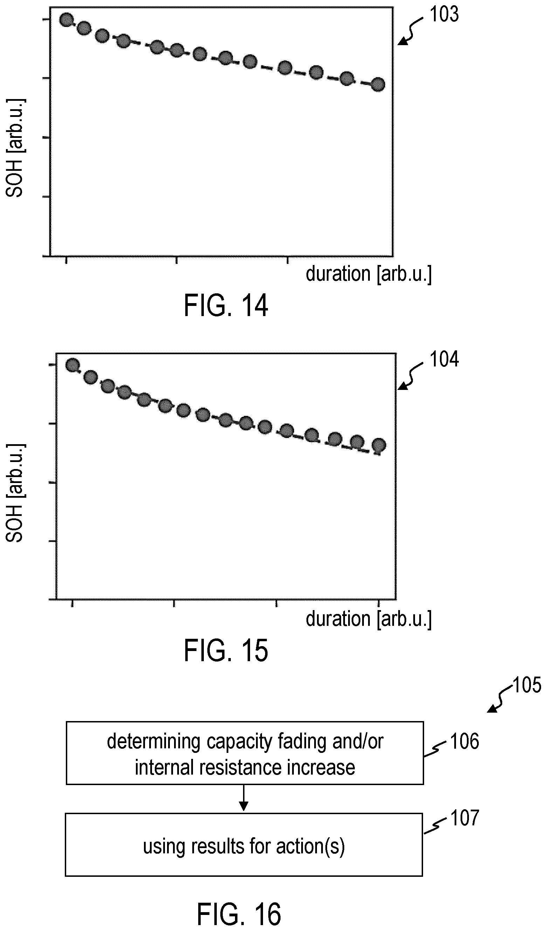

where: $T[K]$ denotes the temperature in Kelvin; $T[°C]$ denotes the temperature in degrees centigrade; $D_2$ is a parameter value of the Arrhenius function; and $D_1$ is another (scaling) coefficient that can optionally be determined or that may be set to a fixed number. The values of the parameter(s) $D_2$ and, if applicable, $D_1$ may be parameter values determined based on a set of aging test data, as will be explained in more detail with reference to Fig. 16, Fig. 17, Fig. 18, Fig. 19, and Fig. 20.

The second function $\beta_{C-rate}(\cdot)$ may be an exponential function of the current rate. For illustration, the second function $\beta_{C-rate}(\cdot)$ may be of the form:

$$\beta_{C-rate}(C-rate) = C_1 \times e^{C_2*C-rate} \qquad (4)$$

where: $C$-rate denotes the current rate; $C_2$ is a parameter value of the exponential function; and $C_1$ is another (scaling) coefficient that can optionally be determined or that may be set to a fixed number. The values of the parameter(s) $C_2$ and, if applicable, $C_1$ may be parameter values determined based on a set of aging test data, as will be explained in more detail with reference to Fig. 16, Fig. 17, Fig. 18, Fig. 19, and Fig. 20.

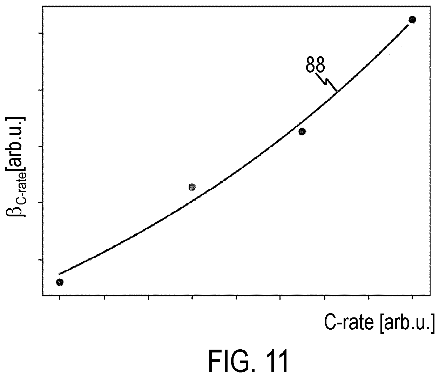

Fig. 11 is a graph showing an exponential curve 88 as well as data points that represent the functional dependence of cycling aging (as exemplified by a change in capacitance) on the current rate (with all other stress factors being the same for the various data points). Thus, the influence of the current rate on cycling aging can be represented by an exponential, e.g., of the form given in Eq. (4).

The third function $\beta_{SOC}(\cdot)$ may be a polynomial function of SOC. The third function $\beta_{SOC}(\cdot)$ may be a polynomial function of the (middle) SOC having a degree greater than one. The third function $\beta_{SOC}(\cdot)$ may be a polynomial function of the (middle) SOC having a degree of equal to two or more than two. For illustration, the third function $\beta_{SOC}(\cdot)$ may be of the form:

$$\beta_{SOC}(SOC) = E_1 \times SOC + E_0 \qquad\qquad (5)$$

or

$$\beta_{SOC}(SOC) = E_2 \times SOC^2 + E_1 \times SOC + E_0 \qquad\qquad (6)$$

where: SOC denotes the state of charge; and $E_0$, $E_1$, and, if applicable, $E_2$ are coefficients of the polynomial. The values of the coefficient(s) may be parameter values determined based on a set of aging test data, as will be explained in more detail with reference to Fig. 16, Fig. 17, Fig. 18, Fig. 19, and Fig. 20.

The fourth function $\beta_{DOD}(\cdot)$ may be a polynomial function of the DOD. The fourth function $\beta_{DOD}(\cdot)$ may be a polynomial function of the DOD having a degree of at least two. The fourth function $\beta_{DOD}(\cdot)$ may be a polynomial function of the DOD having a degree of equal to two or more than two. For illustration, the third function $\beta_{SOC}(\cdot)$ may be of the form:

$$\beta_{DOD}(DOD) = G_2 \times DOD^2 + G_1 \times DOD + G_0 \qquad\qquad (7)$$

where: DOD denotes the state of charge; and $G_0$, $G_1$, and $G_2$ are coefficients of the polynomial. The values of the coefficient(s) may be parameter values determined based on a set of aging test data, as will be explained in more detail with reference to Fig. 16, Fig. 17, Fig. 18, Fig. 19, and Fig. 20.

In additional embodiments, one or more additional stress factors can be taken into account. For illustration, the cycling aging model may have the following form:

$$C_{loss,cyc} = \beta_T(T) \times \beta_{C-rate}(C-rate) \times \beta_{SOC}(SOC) \times \beta_{DOD}(DOD) \times \beta_{rt}(rt) \times t^z \quad (8)$$

where: $rt$ denotes a rest time indicator that quantifies or is otherwise dependent on a rest time (e.g., the duration of a period without charging and discharging operations that immediately precedes the operation under consideration); and $\beta_{rt}(\cdot)$ denotes a fifth function that is a function of the rest time indicator. The fifth function $\beta_{rt}(\cdot)$ may be independent of temperature, current rate, SOC, DOD, and duration $t$. The fifth function $\beta_{rt}(\cdot)$ may be a polynomial function of, e.g., degree one or more, e.g., of degree two or more than two, without being limited thereto.

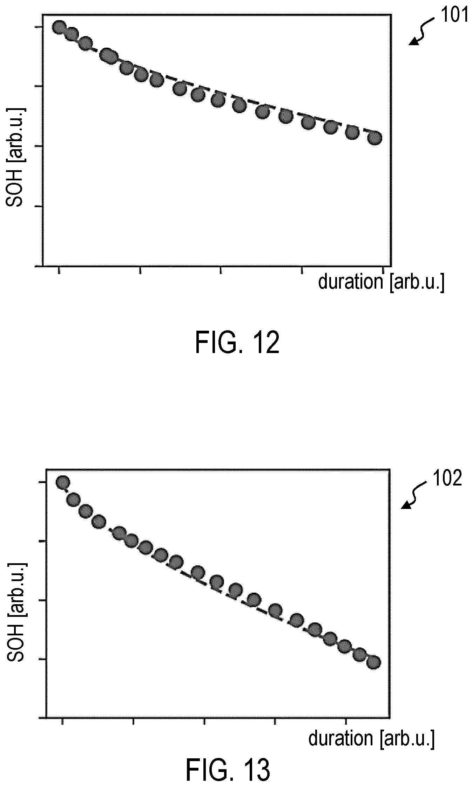

Fig. 12, Fig. 13, Fig. 14, and Fig. 15 show graphs 101, 102, 103, 104, each representing (in the form of filled circles) data obtained by aging tests, respectively as a function of duration of charging or discharging operations. The graphs 101, 102, 103, 104 respectively show capacitance normalized by the BOL capacitance. Within each of the graphs 101, 102, 103, 104, the stress factors other than duration were the same. The stress factors varied between different ones of the graphs 101, 102, 103, 104. Fig. 12, Fig. 13, Fig. 14, and Fig. 15 also show (as broken line) results obtained from a cycling aging model determined as explained with reference to Eq. (1) to Eq. (7). The cycling aging model comprising a power function of the duration over which charging or discharging was performed provides a degradation assessment (e.g., by predicting capacity fading) that has enhanced accuracy as compared to conventional techniques. This applies for a wide range of different stress factors that may be distinguished from each other in one, several, or all of: temperature; SOC; DOD; current rate.

While techniques of performing a battery degradation assessment were described in which capacity fading was determined (i.e., in which a degradation indicator indicative of capacity fading was determined), the techniques disclosed herein are not limited thereto. For illustration, the techniques disclosed herein may comprise evaluating a cycling aging model indicative of an increase of internal resistance of the battery (e.g., of an equivalent circuit model of the battery).

The cycling aging model may then comprise an equation having the following form:

$$R_{inc,cyc} = \beta'_T(T) \times \beta'_{C-rate}(C-rate) \times \beta'_{SOC}(SOC) \times \beta'_{DOD}(DOD) \times \beta'_{rt}(rt) \times t^{z2} \qquad (9)$$

In Equation (9), the various quantities are as follows: $R_{inc,cyc}$ denotes an increase in internal resistance of the battery caused by cycling aging; $t$ denotes the duration of the operation; z2 denotes the power to which the duration is raised; $T$ denotes temperature; $C$-$rate$ denotes a current rate; SOC denotes a middle state of charge (such as a mean or median SOC during the operation); DOD denotes a depth of discharge; $\beta'_T(\cdot)$ denotes another first function that is a function of temperature and that is independent of the duration, the current rate, the SOC, and the DOD; $\beta'_{C-rate}(\cdot)$ denotes another second function that is a function of current rate and that is independent of the duration, the temperature, the SOC, and the DOD; $\beta'_{SOC}(\cdot)$ denotes another third function that is a function of SOC and that is independent of the duration, the temperature; the current rate, and the DOD; and $\beta'_{DOD}(\cdot)$ denotes another fourth function that is a function of DOD and that is independent of the duration, the temperature; the current rate, and the SOC. The "other" functions indicated by an apostrophe may have the same forms (e.g., Arrhenius form for the other first function; exponential for the other second function; polynomials for the other third function and the other fourth function) as the respective functions discussed in association with Eq. (1) to Eq. (8). However, the numerical values of the parameters may be different.

Alternatively or additionally, other stress factors may be taken into consideration in addition or as an alternative to the ones discussed herein. For illustration, the cycling aging model may comprise an equation having the following form:

$$R_{inc,cyc} = \beta'_T(T) \cdot \beta'_{C-rate}(C - rate) \cdot \beta'_{SOC}(SOC) \cdot \beta'_{DOD}(DOD) \cdot \beta'_{rt}(rt) \cdot t^{z2} \qquad (10)$$

In Equation (10), $rt$ denotes a rest time indicator for a rest time, e.g., a duration of the rest time or rest time indicator determined based on the rest time. The rest time may be, e.g., the duration of a rest period without charging and discharging operations that immediately precedes the operation under consideration); and $\beta_{rt}(\cdot)$ denotes a fifth function that is a function of the rest time indicator. The fifth function $\beta_{rt}(\cdot)$ may be independent of temperature, current rate, SOC, DOD, and duration $t.$ The fifth function $\beta_{rt}(\cdot)$ may be a polynomial function of, e.g., degree one or more, e.g., of degree two or more than two, without being limited thereto.

Fig. 16 is a flow chart of a method 105. The method 105 may be performed automatically by the data processing system 20 and/or the system 10.

At process block 106, capacity fading and/or internal resistance increase of a battery is determined based on at least the cycling aging model, which comprises a power function of the duration of the charging or discharging operation. Process block 106 may be implemented using any one of the techniques discussed in association with Fig. 1 to Fig. 15 herein, e.g., using the method of Fig. 3 or the method of Fig. 5.

At process block 107, the method comprises using the results of the degradation assessment, in particular the determined at least one degradation indicator. The method may comprise using the at least one degradation indicator to perform one, several, or all of: a control action that affects electric power system equipment; a vehicle control action (in particular for a battery installed in a vehicle); a HMI control action; predictive maintenance; augmentation scheduling.

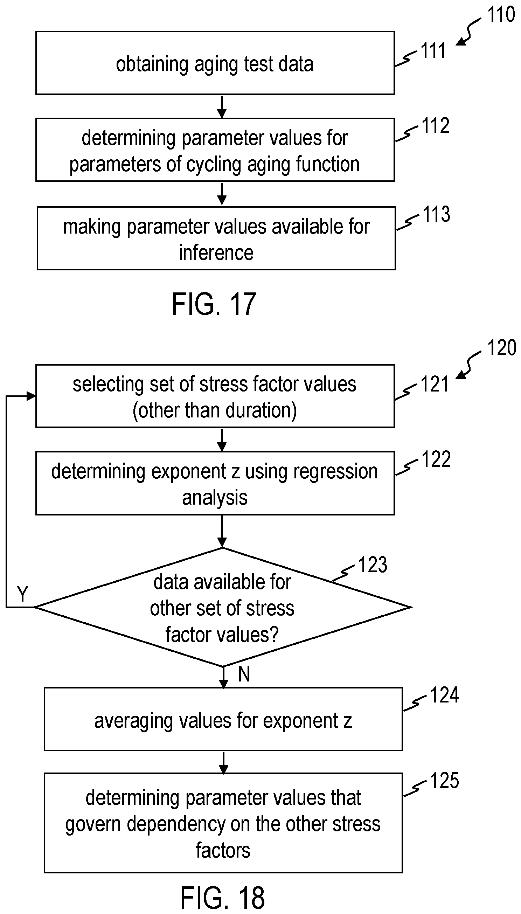

The various parameter values of the cycling aging model (e.g., any of the parameter values that determine the functional dependence of the functions of Eq. (1) to Eq. (10) on their function arguments) may be determined based on aging test data obtained for at least one battery having a same cell type as the battery to which the cycling aging model is to be applied. The parameter values may respectively be determined using techniques such as curve fitting, regression analysis, or other techniques that allow the parameter values to be determined in a manner which results in a (local or preferably global) extremum of a quality metric function. Fig. 17 and Fig. 18 show methods that can be used to determine the various parameter values in a systematic manner.

Fig. 17 is a flow chart of a method 110 of providing a cycling aging model. The method 110 may be performed by the data processing system 20 or by a computing system different from the data processing system 20.

At process block 111, aging test data are obtained. The aging test data may comprise at least one degradation indicator (such as a capacity and/or internal resistance) measured as a function of time when at least one battery undergoes (forced) aging tests. The aging test data may respectively comprise the at least one degradation indicator as a function of time for several sets of stress factors, such as temperature, current rate, (middle) SOC, and/or DOD.

At process block 112, the parameter values of all parameters of the cycling aging model are determined (e.g., the parameter values of the various parameters in Eq. (1) to Eq. (10)). Determining the parameter values may comprise determining the exponent z or z2 that specifies to which power the duration of the charging or discharging operation is raised. The parameter values are determined based on curve fitting, so that the results obtained using the cycling aging model approximate the aging test data to within a predefined quality criterion (which may be determined based on a quality metric).

At process block 113, the determined parameter values are made available for use in performing the degradation assessment for a battery having a same cell type as the battery or batteries for which the aging test data were obtained. The method 110 may further comprise using, by the data processing system 20, the parameter values for performing the degradation assessment.

Fig. 18 is a flow chart of a method 120 of providing a cycling aging model. The method 120 may be performed by the data processing system 20 or by a computing system different from the data processing system 20. The method 120 may be performed to implement process block 112 of the method 110 of Fig. 17.

At process block 121, a set of stress factor values is selected for which aging test data are available.

At process block 122, the exponent z or z2 that defines the power to which the duration is raised in the cycling aging model is determined. Determining the exponent may comprise performing a curve fitting to identify the exponent for which the dependency on duration represented by the power function $t^z$ or $t^{z2}$, respectively, approximates the dependency specified by the aging test data in a manner that complies with a quality criterion (which may be evaluated in accordance with a quality metric).

At process block 123, it is determined whether other aging test data are available for the same or a different set of stress factor values. The method may then return to process block 121. Otherwise, the method may continue at process block 124.

At process block 124, the values for the exponent z or z2 determined in the various iterations at process block 122 may be averaged. The exponent may thus be determined so as to be independent of temperature, SOC, DOD, current rate, and rest time.

At process block 125, the remaining parameter values of the cycling aging model (e.g., of Eq. (1) to Eq. (10)) are determined. Determining the remaining parameter values may comprise: determining the parameter values of the first function (i.e., the function that is a function of temperature and that may be represented as an Arrhenius function); then determining the parameter values of the second function (i.e., the function that is a function of current rate and that may be represented by an exponential function); then determining the parameter values of the fourth function (i.e., the function that is a function of DOD and that may be a polynomial function); then determining the parameter values of the third function (i.e., the function that is a function of SOC and that may be yet another polynomial function). If dependence on rest time is considered, the parameter values of the fifth function (i.e., the function that is a function of rest time) may be determined next.

The method 120 may comprise making the determined parameter values available for use in performing the degradation assessment for a battery having a same cell type as the battery or batteries for which the aging test data were obtained. The method 120 may further comprise using, by the data processing system 20, the parameter values for performing the degradation assessment.

An implementation of the method 120 will be explained in more detail: A regression of SOHQ (i.e., the capacity) as a function of time is determined by power function with the parameter $z$ (i.e., the exponent defining the power to which the duration is raised) being determined. If $z$ is equal to 1, a linear trend between capacity fading and aging time is predicted. The exponent z may be determined for each cycling curve is determined using curve fitting, and then, the average value of $z$ is determined and used. The expression of $\sigma$ which models the effect of the remaining stress factors are listed in below equations. The expression of each stress factor will be obtained in the sequence of T, current rate, DOD and SOC.

$$SOHQ(cyc) = 1 - \sigma * t^z \qquad (11)$$

$$\sigma = \eta \times \beta_T(T) \times \beta_{C-rate}(C-rate) \times \beta_{SOC}(SOC) \times \beta_{DOD}(DOD) \qquad (12)$$

In Eq. (12), $\eta$ represents an optional global scaling factor that may be incorporated into either one of the first, second, third, and fourth functions. Referring to the current rate dependence as an example, as shown in Fig. 11, four aging curves with different current rates are illustrated. The other stress factors (T, SOC, DOD, and, if applicable, rest time $rt$) of these four curves are the same following simple variable method. Fitting techniques may be used to determine the parameter values of the exponential function of Eq. (4). Similar techniques may then be applied to the remaining factors on the right-hand side of Eq. (12).

During fitting, any one of a variety of quality metrics may be used to quantify the agreement of the curve to the aging test data. This similarly applies during validation. For illustration, any one or any combination of the following quality metrics may be used:

$$RMSE = \sqrt{\frac{\sum_{i=1}^{N}(Predicted_i - Exp_i)^2}{N}} \qquad (14)$$

$$max.e = \max(Predicted_i - Exp_i) \qquad (15)$$

$$error\ ratio = \frac{\sum_{i=1}^{N}\frac{(Predicted_i - Exp_i)}{Exp_i}}{N} \qquad (16)$$

$$predict\_error = \frac{\sum_{i=1}^{N}(Predicted_i - Exp_i)}{N} \qquad (17)$$

Here, N is a number of available data elements (e.g., different durations) for which the curve is available. The quantity $Predicted_i$ denotes the $i^{th}$ data element as predicted based on the equations. The quantity $Exp_i$ denotes the $i^{th}$ data element as included in the aging test data.

Examples of validation results showing the high prediction accuracy are provided in Fig. 12, Fig. 13, Fig. 14, and Fig. 15.

The method 110 of Fig. 17 and/or the method 120 of Fig. 18 may comprise validating the cycling aging model, wherein the cycling aging model is made available for use in performing the degradation assessment selectively dependent on the quality metric complying with, e.g., a threshold criterion.

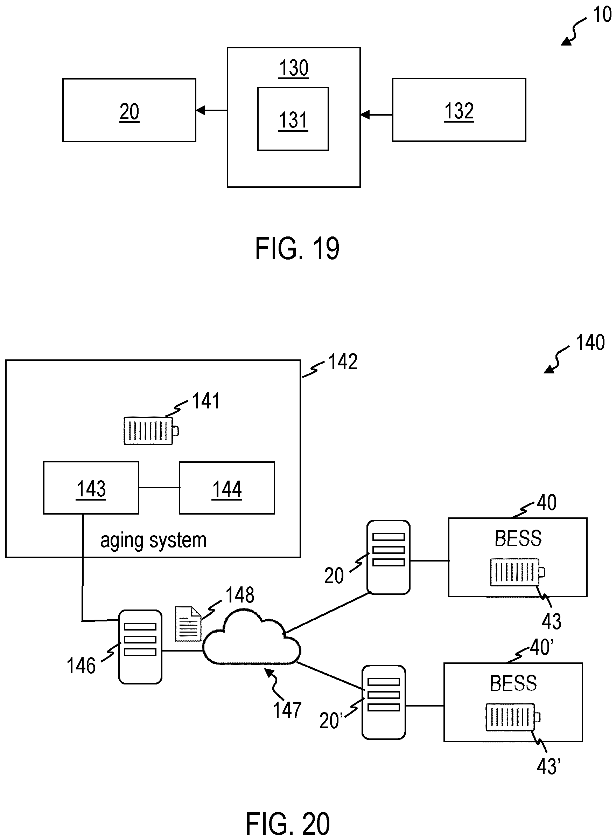

Fig. 19 is a schematic representation to further illustrate operation of the data processing system 20 and of the methods disclosed herein. Aging test data 132 are processed by a computing system 130 to determine parameter values 131 of several parameters of the cycling aging model. The parameter values 131 may comprise at least one parameter value of an exponent to which a duration of an operation that is a charging or discharging operation is raised in the cycling aging model. The computing system 130 may be operative to determine the parameter values 131 using the method 110 of Fig. 17 and/or the method 120 of Fig. 18. The computing system 130 may be implemented as a server system. The computing system 130 may comprise one or several computing circuits operative to perform the method 110 of Fig. 17 and/or the method 120 of Fig. 18. The data processing system 20 may be operative to communicatively interface with the computing system 130 to obtain the parameter values that define the cycling aging model for the battery cell type for which the data processing system 20 is to perform the degradation assessment.

Fig. 20 is a schematic representation of a system 140 that may be operative to determine the cycling aging model and provide the cycling aging model to the data processing system 20 for use in the degradation assessment. The system 140 comprises a computing system 146 operative to determine the parameter values for the cycling aging model based on aging test data, with the cycling aging model comprising a power function of a duration for which a charging or discharging operation is performed. Thereby, the cycling aging model is provided so as to be operative to determine at least one degradation indicator that quantifies, e.g., capacity fading and/or internal resistance increase caused by the operation. To determine the parameter values of the cycling aging model, the computing system 146 may be operative to communicatively interface with an aging system 142. The aging system 142 is operative to expose an aging test battery 141 to stress (such as thermal stress, current stress, DOD stress, and/or SOC stress) in a controllable manner. The aging system 142 may comprise a stress source 144 operative to expose the aging test battery to stress in a controllable manner. The stress source 144 may comprise any one or any combination of a thermal stress source; a current stress source; a DOD stress source; a SOC stress source. The aging system 142 may comprise a control system 143 operative to control the stress source 144. The computing system 146 may be operative to communicatively interface with the control system 143 to cause degradation of the SOH of the aging test battery 141 over several cycles. The computing system 146 may perform the method 110 of Fig. 17 and/or the method 120 of Fig. 18 to provide the cycling aging model.

The computing system 146 may be operative to provide the cycling aging model to the data processing system 20 that is operative to perform the degradation assessment for a BESS 40 having a battery 43 with an identical battery cell type as the aging test battery 141. Providing the data-driven processing model may comprise providing data 148 defining the parameter values determined by the computing system 146. The computing system 146 may be operative to provide the parameter values 148 via a communication system 147 which may comprise a wide area network (WAN) and/or a cellular communication system. The data processing system 20 may be operative to obtain the parameter values, e.g., by communicatively interfacing with the computing system 146. The data processing system 20 may be operative to persistently store the parameter values, which define the data-driven processing model, and use the parameter values to apply the data-driven processing model 34.

The data-driven processing model may be provided to more than one processing system 20. For illustration, a further processing system 20' or several further processing systems 20' may be operative to receive the parameter values 148 that define the cycling aging model, and may use the same for performing a degradation assessment of a further BESS 40' having a further battery 43' with a same battery cell type as the aging test battery 141.

Various effects and advantages are attained by the data processing system and the methods. The method and data processing system allow the battery degradation to be determined in a time-based manner, by determining a duration of a charging or discharging operation and computing a power function of the duration. The techniques disclosed herein facilitate combination of cycling aging model predictions with calendar aging model predictions, with the latter being also determined based on a further power function of a rest period. The techniques disclosed herein provide enhanced accuracy for quantifying degradation of a battery during charging or discharging. This provides a technical effect over techniques such as those of WO 2021/044134 A1. For illustration, the techniques disclosed herein provide enhanced accuracy for assessing battery degradation in a manner that can be readily integrated into the field operation of a BESS.

While embodiments have been described in detail with reference to the drawings, various modifications may be implemented in other embodiments. For illustration rather than limitation:

- While embodiments have been described in which various stress factors were considered, alternative or additional stress factors can be considered.

- While embodiments have been described in association with a BESS of an electric power system (such as a power grid), the techniques may similarly be applied to other batteries, e.g., to traction batteries of electric vehicles.

Embodiments may be used in association with a power grid having renewables penetration, such as power grid comprising renewable energy systems (such as DERs), and/or HVDC systems, without being limited thereto.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the spirit and scope of this description and the claims. In some instances, well-known circuits, structures, and techniques have not been shown in detail in order not to obscure the invention. Thus, it will be understood that changes and modifications may be made by those of ordinary skill within the scope and spirit of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

**Claims**

1. A method of performing a battery degradation assessment, the method comprising:

    obtaining, by a data processing system (20; 20, 20'), battery-related data (24) for a battery (43; 43, 43'), the battery-related data (24) comprising time information for several charging and/or discharging operations (72, 74, 75);
    determining, by the data processing system (20; 20, 20'), a degradation indicator (85) for the battery based on the battery-related data (24), comprising:

    determining, based on the time information, a duration (78) for which an operation (72, 74, 75) was carried out, the operation (72, 74, 75) being a charging operation (72, 74) or a discharging operation (75);
    evaluating a cycling aging model (33), wherein the cycling aging model (33) comprises a power function of the duration (78), wherein the degradation indicator (85) is determined based at least on the cycling aging model (33).

2. The method of claim 1, wherein the time information comprises a start time (78.1) and an end time (78.2) of the operation (72, 74, 75), and wherein determining the duration (78) comprises determining the duration (78) based on the start time (78.1) and the end time (78.2).

3. The method of claim 1 or claim 2, wherein determining the degradation indicator (85) comprises determining several durations (78), each quantifying a duration (78) of one of the several charging and/or discharging operations (72, 74, 75), and wherein determining the degradation indicator (85) further comprises evaluating the cycling aging model (33) comprising the power function of the respective duration (78) for each of the several charging and/or discharging operations (72, 74, 75).

4. The method of claim 3, wherein determining the degradation indicator (85) comprises determining an accumulated cycling aging over the several charging and/or discharging operations (72, 74, 75).

5. The method of any one of the preceding claims, wherein the cycling aging model (33) is further dependent on at least one parameter different from the duration (78), wherein the at least one parameter comprises one or several of: a temperature; a state of charge; a depth of discharge; a current rate; rest time.

6. The method of claim 5, wherein the cycling aging model (33) comprises a product of the power of the duration (78) and at least one function, the at least one function being a function of the at least one parameter and being independent of the duration (78).

7. The method of claim 5 or claim 6, wherein determining the degradation indicator (85) comprises obtaining values of the at least one parameter for each of the several charging and/or discharging operations (72, 74, 75) from the battery-related data (24).

8. The method of any one of the preceding claims, determining the degradation indicator (85) further comprises:

   identifying, based on the battery-related data (24), at least one time interval (71, 73) in which the battery is neither charged nor discharged; and
   evaluating a calendar aging model (34) for the at least one time interval (71, 73), the calendar aging model (34) being different from the cycling aging model (33).

9. The method of any one of the preceding claims, wherein the battery-related data (24) originate from a battery management system, BMS (42), of the battery or from another data logging system for the battery (43).

10. The method of claim 9, wherein obtaining the battery-related data (24) comprises communicatively interfacing, by the data processing system (20; 20, 20'), with the BMS (42) or with the other data logging system,.
    optionally wherein communicatively interfacing with the BMS (42) or with the other data logging system comprises establishing a data connection over a wide area network.

11. The method of any one of the preceding claims, wherein the cycling aging model (33) quantifies at least one of the following caused by the operation:

    a capacity reduction;
    a resistance increase;
    another health indicator.

12. The method of any one of the preceding claims, further comprising causing, by the data processing system (20; 20, 20'), at least one of:

    a control operation based on the degradation indicator (85);
    predictive maintenance based on the degradation indicator (85);
    augmentation scheduling based on the degradation indicator (85).

13. The method of any one of the preceding claims, wherein the battery is

    a battery (43) of an energy storage system, ESS (40), of at least one of: an electric power system (10), a microgrid, a distributed energy resource;
    a traction battery of an electric vehicle.

14. A data processing system (20; 20, 20') for performing a battery degradation assessment, the data processing system (20; 20, 20') comprising:

    at least one interface (21) operative to obtain battery-related data (24) for a battery, the battery-related data (24) comprising time information for several charging and/or discharging operations (72, 74, 75);
    at least one processing circuit (30) operative to determine a degradation indicator (85) for the battery based on the battery-related data (24), the at least one processing circuit (30) being operative to:

       determine, based on the time information, a duration (78) for which an operation was carried out, the operation being a charging operation or a discharging operation;
       evaluate a cycling aging model (33), wherein the cycling aging model (33) comprises a power function of the duration (78), wherein the degradation indicator (85) is determined based at least on the cycling aging model (33).

**15.** Machine-readable instruction code comprising instructions which, upon execution by at least one programmable circuit of a data processing system (20; 20, 20'), cause the data processing system (20; 20, 20') to perform the method of any one of claims 1 to 13.

storage system

28    29

23    30    20

24    21    31

degradation indicator determination

time information determination

32

cycling aging model

33

1st interface

26

2nd interface

22

25

42

processing circuit(s)

data processing system

FIG. 1

FIG. 2

obtaining battery-related data comprising time information — 61

determining duration of charging and/or discharging operation(s) — 62

evaluating cycling aging model — 63

60

## FIG. 3

31

30

degradation indicator determination

time information determination — 32

calendar aging model — 34

cycling aging model — 33

combiner — 35

interface controller — 36

processing circuit(s)

## FIG. 4

obtaining battery-related data comprising time information ⟋61

65

determining further duration of periods without charging/discharging ⟋66

determining duration of charging and/or discharging operation(s) ⟋62

evaluating calendar-based aging model ⟋67

evaluating cycling aging model ⟋63

combining results ⟋68

action(s) ⟋69

FIG. 5

| 71 | 72 | 73 | 74 | 75 |

70

76    78.1    78    78.2    77

FIG. 6

81

83

82

84

cycling aging model

33

85

FIG. 7

FIG. 8

FIG. 9

FIG. 10

FIG. 11

FIG. 12

FIG. 13

FIG. 14

FIG. 15

FIG. 16

```
                                                    ⟋ 110
┌─────────────────────────────────┐  ⟋ 111  ⤺
│                                 │
│     obtaining aging test data   │
│                                 │
└─────────────────────────────────┘
                 │
                 ▼
┌─────────────────────────────────┐  ⟋ 112
│  determining parameter values for│
│ parameters of cycling aging function│
└─────────────────────────────────┘
                 │
                 ▼
┌─────────────────────────────────┐  ⟋ 113
│ making parameter values available for│
│            inference             │
└─────────────────────────────────┘
```

## FIG. 17

```
                                                       ⟋ 120
   ┌──────────────────────────────────┐  ⟋ 121  ⤺
   │   selecting set of stress factor values│
─▶ │       (other than duration)      │
   └──────────────────────────────────┘
                    │
                    ▼
   ┌──────────────────────────────────┐  ⟋ 122
   │  determining exponent z using regression│
   │             analysis             │
   └──────────────────────────────────┘
                    │
                    ▼
              ╱──────────────╲      ⟋ 123
            ╱   data available for   ╲
      Y    ╱   other set of stress    ╲
◀─────────⟨        factor values?       ⟩
            ╲                        ╱
              ╲──────────────╱
                    │ N
                    ▼
   ┌──────────────────────────────────┐  ⟋ 124
   │       averaging values for exponent z│
   └──────────────────────────────────┘
                    │
                    ▼
   ┌──────────────────────────────────┐  ⟋ 125
   │  determining parameter values that│
   │ govern dependency on the other stress│
   │              factors             │
   └──────────────────────────────────┘
```

## FIG. 18

10

130

20

131

132

FIG. 19

140

142

141

143          144

aging system

148

146

147          20'

20

40

BESS

43

40'

BESS

43'

FIG. 20

Europäisches
Patentamt
European
Patent Office
Office européen
des brevets

# EUROPEAN SEARCH REPORT

**Application Number**

EP 24 20 3416

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2020 124182 A1 (TWAICE TECH GMBH [DE]) 17 March 2022 (2022-03-17) * paragraph [0050] - paragraph [0192] * * claim 4 * * figures 1-6 * | 1-15 | INV.<br>G01R31/367<br>G01R31/392<br>B60L58/16 |
| A | BHARTI SOUMYA ET AL: "Optimal Parameter Estimation of CAPN Model for Li-ion Battery", 2023 INTERNATIONAL CONFERENCE ON COMPUTER, ELECTRONICS & ELECTRICAL ENGINEERING & THEIR APPLICATIONS (IC2E3), IEEE, 8 June 2023 (2023-06-08), pages 1-6, XP034436810, DOI: 10.1109/IC2E357697.2023.10262727 [retrieved on 2023-09-29] * page 3, left-hand column, paragraph II - page 6, left-hand column, paragraph VI * | 1-15 | |

**TECHNICAL FIELDS
SEARCHED      (IPC)**

G01R
B60L

The present search report has been drawn up for all claims

| Place of search | Date of completion of the search | Examiner |
|---|---|---|
| Munich | 26 February 2025 | Sedlmaier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 3416

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2025

| Patent document cited in search report | Publication date | Patent family member(s) | Publication date |
|---|---|---|---|
| DE 102020124182 A1 | 17-03-2022 | DE 102020124182 A1 | 17-03-2022 |
| | | EP 4168813 A1 | 26-04-2023 |
| | | WO 2022058416 A1 | 24-03-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021044134 A1